## Europäisches Patentamt

## European Patent Office

## Office européen des brevets

(19)

(11) Numéro de publication: **0 078 194**
**A1**

(12) **DEMANDE DE BREVET EUROPEEN**

(21) Numéro de dépôt: **82401898.0**

(22) Date de dépôt: **15.10.82**

(51) Int. Cl.³: **H 01 L 23/52**
**H 01 L 25/04, H 01 L 21/60**
**H 01 L 23/14**

(30) Priorité: **27.10.81 FR 8120164**

(43) Date de publication de la demande:
**04.05.83 Bulletin 83/18**

(84) Etats contractants désignés:
**DE GB NL**

(71) Demandeur: **THOMSON-CSF**
**173, Boulevard Haussmann**
**F-75379 Paris Cedex 08(FR)**

(72) Inventeur: **Descure, Patrick**
**THOMSON-CSF SCPI 173, bld Haussmann**
**F-75379 Paris Cedex 08(FR)**

(72) Inventeur: **Fraleux, Jean-Ernest**
**THOMSON-CSF SCPI 173, bld Haussmann**
**F-75379 Paris Cedex 08(FR)**

(72) Inventeur: **Reboul, Jean-Philippe**
**THOMSON-CSF SCPI 173, bld Haussmann**
**F-75379 Paris Cedex 08(FR)**

(74) Mandataire: **Mayeux, Michèle et al,**
**THOMSON-CSF SCPI 173, Bld Haussmann**
**F-75379 Paris Cedex 08(FR)**

(54) **Procédé de fabrication d'un boîtier comportant au moins deux circuits intégrés.**

(57) On rend obliques certaines parois latérales des circuits intégrés (A et B) de façon à ce qu'elles fassent un angle de 45° environ avec le plan des circuits intégrés. On recouvre ces parois d'une couche d'isolement (3). Il est ainsi possible de réaliser simultanément toutes les connexions (C) du boîtier par dépôt métallique en réalisant, notamment, des connexions sur certaines parois latérales des circuits intégrés qui ont été rendues obliques et recouvertes d'une couche d'isolement (3).

FIG_ 3

EP 0 078 194 A1

### PROCEDE DE FABRICATION D'UN BOITIER
### COMPORTANT AU MOINS DEUX CIRCUITS INTEGRES

La présente invention concerne un procédé de fabrication d'un boîtier comportant au moins deux circuits intégrés, et dans lequel il faut réaliser de nombreuses connexions, notamment, entre les plots des circuits intégrés, et entre les plots des circuits intégrés et ceux du boîtier.

Il est connu de réaliser toutes ces connexions en reliant les plots par des fils d'or ou d'aluminium qui sont soudés aux plots par thermocompression ou par ultra-sons.

L'inconvénient de cette technique est qu'il est très long de réaliser toutes ces soudures. De plus, il peut y avoir des soudures défectueuses, et de toutes façons, le boîtier est très sensible aux chocs et aux vibrations.

Dans les circuits hybrides, on utilise une technique différente pour réaliser les connexions. En effet, dans les circuits hybrides, on trouve un substrat passif qui, par impression ou par gravure, reçoit un réseau de connexions et des composants passifs. Les éléments actifs, tels que les circuits intégrés, sont ajoutés ensuite et soudés. On complète les connexions du circuit hybride en soudant des fils entre les plots des circuits intégrés et le réseau de connexions imprimé ou gravé sur le substrat passif, et entre les plots des circuits intégrés et les plots de sortie du circuit hybride.

On retrouve là encore les inconvénients dus à un grand nombre de soudures.

La présente invention concerne un procédé de fabrication d'un boîtier comportant au moins deux circuits intégrés. Des connexions relient notamment, les plots des circuits intégrés entre eux et, les plots des circuits intégrés aux plots du boîtier.

Le procédé selon l'invention comporte les étapes suivantes :

- 1°) on rend obliques certaines parois latérales des circuits intégrés qui ont initialement des sections sensiblement rectangulaires ;

- 2°) ces parois sont recouvertes d'une couche d'isolement (3) ;

- 3°) les connexions (C) sont réalisées par dépôt métallique et passent sur les parois latérales rendues obliques.

Selon l'invention, toutes les connexions sont réalisées en une fois, par dépôt métallique, par évaporation sous vide par exemple. En rendant obliques certaines parois latérales des circuits intégrés et en recouvrant ces parois d'une couche d'isolement, on peut déposer des connexions sur ces parois, ce qui n'est pas possible lorsque ces parois latérales sont laissées verticales. On est alors obligé d'utiliser des fils soudés pour réaliser les connexions avec les plots des circuits intégrés.

La présente invention supprime les inconvénients dus à un grand nombre de soudures. Les connexions sont réalisées en une fois et donc beaucoup plus rapidement que lorsqu'on doit les réaliser par soudures. Les connexions sont réalisées de façon plus sûre : il n'y a pas de risques d'oubli de soudures, ou de soudures défectueuses. Le boîtier obtenu par la présente invention est très résistant aux chocs et aux vibrations.

La présente invention permet d'obtenir de nombreuses connexions de faible largeur, de l'ordre de 10 micromètres de largeur, alors que les techniques utilisées, par exemple dans les circuits hybrides, pour réaliser les connexions ne permettent d'obtenir que des connexions de l'ordre de 300 micromètres de largeur. De plus, la présente invention permet de réaliser des connextions rapprochées, séparées par un intervalle de 50 µm par exemple, alors que les techniques connues utilisant par exemple une tête de thermocompression ne permettent pas de descendre au-dessous d'un intervalle de 100 µm par exemple. La présente invention permet donc une plus grande intégration que celle permise par les techniques connues.

Enfin, le procédé selon l'invention présente le grand avantage d'utiliser des circuits intégrés standards de section transversale sensiblement rectangulaire.

D'autres objets, caractéristiques et résultats de l'invention ressortiront de la description suivante, donnée à titre d'exemple non limitatif et illustrée par les figures annexées qui représentent :

- la figure 1, une vue en perspective de deux circuits intégrés A et B entre lesquels on veut réaliser des connexions ;

- la figure 2, une vue en perspective montrant les parois latérales en vis-à-vis des deux circuits intégrés A et B qui sont rendues obliques et recouvertes d'une couche d'isolement ;

- la figure 3, une vue en perspective montrant les connexions entre les deux circuits intégrés A et B qui sont, notamment, déposées sur les parois latérales des circuits intégrés rendues obliques et recouvertes d'une couche d'isolement ;

- la figure 4, une vue en coupe transversale montrant une disposition particulière des circuits intégrés.

Sur les différentes figures, les mêmes repères désignent les mêmes éléments, mais, pour des raisons de clarté, les cotes et proportions des divers éléments ne sont pas respectées.

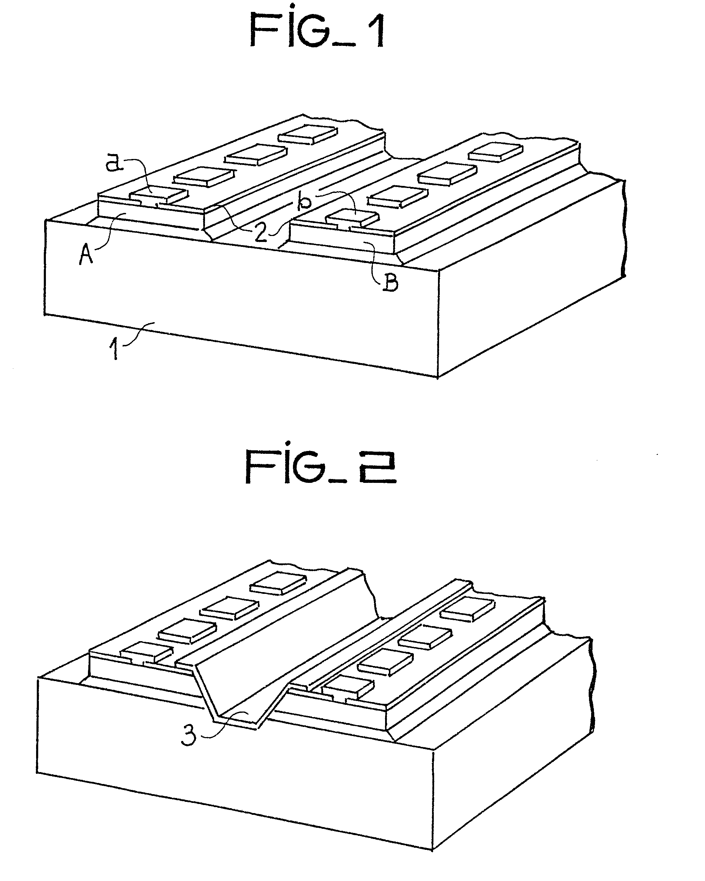

La figure 1 représente une vue en perspective de deux circuits intégrés A et B entre lesquels on veut réaliser des connexions. Ces circuits intégrés sont portés par un substrat passif 1 et leur section tranversale est sensiblement rectangulaire. La face supérieure des circuits intégrés A et B est recouverte d'une couche de passivation 2 que traversent les plots des circuits A et B, qui sont respectivement désignés par a et b.

Il est bien entendu que les deux circuits intégrés A et B de la figure 1 et leur support 1 sont contenus dans un boîtier comportant des plots auxquels doivent aboutir des connexions. Par souci de simplification, le boîtier et ses plots ne sont pas représentés sur les figures.

L'invention que nous décrivons est utilisée lorsqu'il y a de nombreuses connexions à réaliser, c'est-à-dire lorsqu'il s'agit d'obtenir un boîtier comportant au moins deux circuits intégrés. Il est bien évident qu'en plus des deux circuits intégrés, on peut trouver sur le substrat passif des composants passifs, comme des résistances ou des condensateurs, sous forme de composants discrets, ou réalisés sur le substrat passif, par impression ou par gravure, ou en même temps que les connexions.

La figure 2 représente une vue en perspective dans laquelle on montre que les parois latérales en vis-à-vis des deux circuits intégrés A et B de la figure 1 sont rendues obliques. La section transversale des circuits intégrés est rendue sensiblement trapézoïdale.

Pour usiner les parois des circuits intégrés, on peut procéder de différentes façons : on peut utiliser par exemple une scie abrasive, un outil ultra-sonique, un mandrin d'électro-érosion ; on peut aussi procéder par érosion chimique.

Après usinage, les parois obliques des circuits intégrés font de préférence un angle de sensiblement 45° environ avec le plan des circuits intégrés. La valeur de cet angle peut varier dans de grandes proportions, entre 30 et 45° par exemple, mais il doit bien entendu rester bien inférieur à 90° pour qu'il soit possible de déposer aisément sur les parois obliques une couche d'isolement et des connexions.

Pendant l'usinage des parois latérales des circuits intégrés, on doit protéger les circuits intégrés en utilisant des techniques bien connues.

On recouvre ensuite les parois latérales obliques des circuits intégrés par une couche d'isolement 3.

Sur la figure 2, on constate que la couche d'isolement 3 recouvre les parois latérales obliques des circuits intégrés, mais aussi une partie de la face supérieure des circuits intégrés A et B, qui est recouverte de la couche de passivation 2, ainsi que la partie du substrat passif 1 séparant les circuits intégrés A et B. Ainsi, en faisant se superposer la couche d'isolement 3 et la couche de passivation 2, on assure une bonne protection des parties sensibles des circuits intégrés A et B qui ont été découvertes par l'usinage des parois latérales.

Pour obtenir cette couche d'isolement, on peut procéder de différentes façons : on peut procéder, par exemple, par évaporation sous vide, par pulvérisation cathodique. On peut aussi effectuer un dépôt de verre de phospho-silicate.

Etant donné l'état de surface des parois obliques dont la rugosité peut être de l'ordre de 1 à 2 micromètres, une couche d'isolement 3 de l'ordre de O,5 à 1 micromètre est nécessaire.

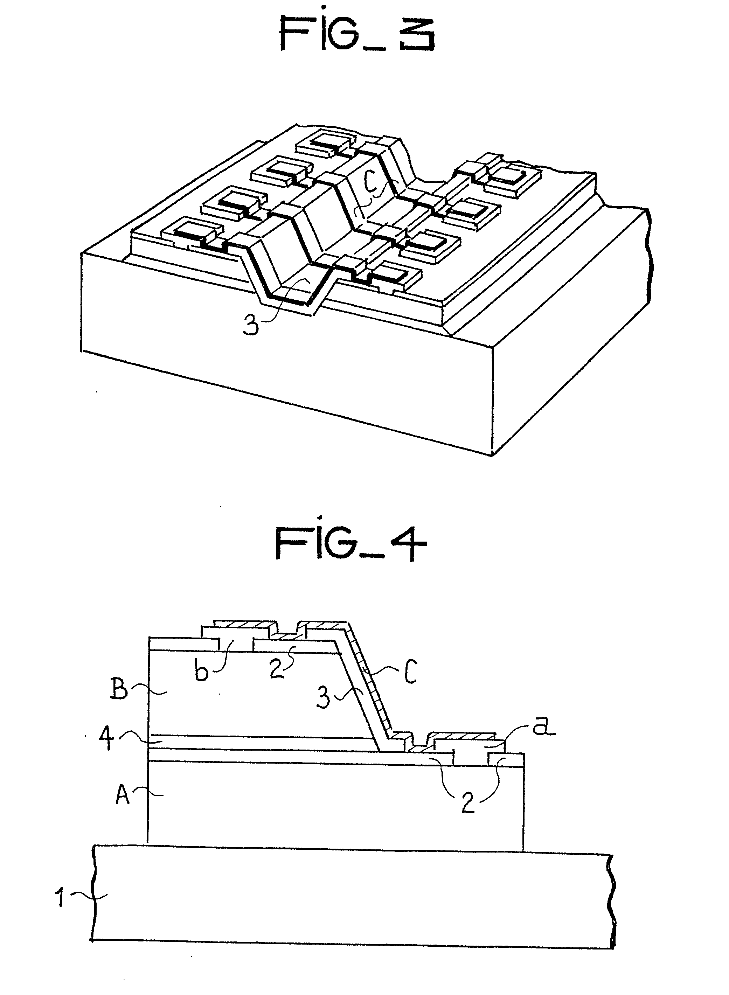

La figure 3 montre comment sont réalisées les connexions C entre les deux circuits intégrés A et B.

On dépose partout où l'on doit réaliser des connexions une couche uniforme de métal, par exemple de l'aluminium.

On peut utiliser un dépôt sous vide ou un dépôt par voie chimique de type "electroless".

On dépose ainsi une couche métallique, en particulier, sur les parois latérales obliques des circuits intégrés qui sont recouvertes de la couche d'isolement 3.

Par photogravure de la couche métallique déposée, on obtient ensuite les connexions recherchées en une fois.

Selon un mode de réalisation préféré de l'invention, il est possible d'effectuer le dépôt de la couche métallique par évaporation sous vide à travers des masques stencils servant de pochoirs pour obtenir en une fois toutes les connexions souhaitées.

Les connexions peuvent être réalisées sans problème même si les circuits intégrés sont de hauteurs differentes.

La figure 4, montre une vue en coupe transversale d'une disposition particulière des circuits intégrés.

Sur les figures 1, 2 et 3, on constate que les circuits intégrés A et B sont fixés, côte à côte, à plat, sur un substrat passif 1.

Sur la figure 4, au contraire, on constate que les deux circuits intégrés A et B sont superposés.

Le circuit intégré A est fixé, à plat, sur le substrat passif 1.

Le circuit intégré B est fixé, par exemple par de la colle, sur la face supérieure du circuit intégré A, et il n'occupe qu'une partie de cette face supérieure.

Il est bien entendu que la face supérieure des circuits intégrés A et B est recouverte d'une couche de passivation 2.

Les deux "puces" A et B de la figure 4 comportent des plots a et b.

Selon l'invention, pour connecter les plots a et b des deux "puces" A et B, on rend oblique l'une des parois latérales du circuit intégré le moins encombrant, c'est-à-dire dans l'exemple de la figure 4, du circuit B, les deux circuits intégrés ayant initialement des sections transversales sensiblement rectangulaires.

On recouvre cette paroi oblique d'une couche d'isolement 3.

On réalise ensuite les connexions C :

- soit en déposant une couche métallique uniforme partout où l'on doit réaliser des connexions C, puis en utilisant la photogravure ;

- soit en déposant une couche métallique à travers des masques adaptés.

Les circuits intégrés dont les connexions sont réalisées de la façon qui vient d'être exposée peuvent être, par exemple, des mémoires, des multiplexeurs, des lignes à retard ou des barrettes de photo-détecteurs. Il est bien entendu que l'on peut connecter entre eux des circuits intégrés réalisés sur des substrats semi-conducteurs de nature différente.

## REVENDICATIONS

1. Procédé de fabrication d'un boîtier comportant au moins deux circuits intégrés (A et B), des connexions (C), reliant, notamment, les plots des circuits intégrés entre eux et les plots des circuits intégrés à ceux du boîtier, caractérisé en ce qu'il comporte les étapes suivantes :

- 1°) on rend obliques certaines parois latérales des circuits intégrés qui ont initialement des sections sensiblement rectangulaires ;

- 2°) ces parois sont recouvertes d'une couche d'isolement (3) ;

- 3°) les connexions (C) sont réalisées par dépôt métallique et passent sur des parois latérales rendues obliques.

2. Procédé selon la revendication 1, caractérisé en ce que les parois obliques des circuits intégrés font un angle de sensiblement 45° avec le plan des circuits intégrés.

3. Prodédé selon l'une des revendications 1 ou 2, caractérisé en ce que les circuits intégrés (A et B) sont fixés côte à côte, à plat, sur un substrat passif (1), ou, sont superposés, un circuit intégré (A), fixé sur le substrat passif, ayant un autre circuit intégré (B) fixé sur sa face supérieure recouverte d'une couche de passivation (2).

4. Procédé selon l'une des revendications 1 à 3, caractérisé en ce que les parois latérales des circuits, sont rendues obliques en utilisant une scie abrasive, un outil ultra-sonique, un mandrin d'électro-érosion ou en utilisant l'érosion chimique.

5. Procédé selon l'une des revendication 1 à 4, caractérisé en ce que la couche d'isolement (3) est obtenue par évaporation sous vide ou par pulvérisation cathodique.

6. Procédé selon l'une des revendications 1 à 4, caractérisé en ce que la couche d'isolement (3) est en verre de phospho-silicate.

7. Procédé selon l'une des revendications 1 à 6, caractérisé en ce que les connexions métalliques (C) sont réalisées par dépôt métallique sous vide ou par dépôt métallique par voie chimique.

8. Procédé selon la revendication 7, caractérisé en ce que les

8

connexions sont réalisées par photogravure de la couche métallique déposée.

9. Procédé selon la revendication 7, caractérisé en ce que les connexions métalliques (C) sont réalisées par dépôt métallique à travers des masques.

FIG_1

FIG_2

# FIG_3

# FIG_4

**Office européen des brevets**

# RAPPORT DE RECHERCHE EUROPEENNE

Numéro de la demande

EP 82 40 1898

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| X | GB-A-1 250 248 (FERRANTI)<br><br>* figure 6; page 2, lignes 88-118; page 2, lignes 29-36 * | 1,3,4 7 | H 01 L 23/52<br>H 01 L 25/04<br>H 01 L 21/60<br>H 01 L 23/14 |
| A | FR-A-1 567 695 (SIEMENS)<br>* figures 1,2; page 4, ligne 41 - page 5, ligne 21 * | 3 | |
| A | DE-A-2 930 460 (LICENTIA)<br>* revendications 1,7,11; page 9, lignes 18-21 * | 4,6,7 | |
| A | GB-A-2 047 466 (INT. COMPUTERS)<br>* page 3, lignes 20-25, 115-128 * | 4,7,8 | |

**DOMAINES TECHNIQUES RECHERCHES (Int. Cl. ³)**

H 01 L

Le présent rapport de recherche a été établi pour toutes les revendications

| Lieu de la recherche<br>LA HAYE | Date d'achèvement de la recherche<br>05-02-1983 | Examinateur<br>DE RAEVE R.A.L. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82